# EUROPÄISCHE PATENTSCHRIFT

(11) **EP 3 757 589 B1**
(45) Veröffentlichungstag und Bekanntmachung des Hinweises auf die Patenterteilung: **09.08.2023**
(21) Anmeldenummer: 20180981.1
(22) Anmeldetag: 19.06.2020
(51) Int. Cl.: H01R 11/32, H01R 101/00, G01R 31/364, H01M 10/48, H01R 11/28, H01R 13/66

(54) **BATTERIESENSOR UND VERFAHREN ZUR HERSTELLUNG EINES BATTERIESENSORS**
BATTERY SYSTEM AND METHOD FOR PRODUCING A BATTERY SYSTEM
DÉTECTEUR DE BATTERIE ET PROCÉDÉ DE FABRICATION D'UN DÉTECTEUR DE BATTERIE

(30) Priorität: 25.06.2019 DE 102019209182
(43) Veröffentlichungstag der Anmeldung: 30.12.2020
(73) Patentinhaber: Continental Automotive Technologies GmbH, 30165 Hannover (DE)
(72) Erfinder: Frenzel, Henryk, 60488 Frankfurt am Main (DE); Spörl, Christine, 60488 Frankfurt am Main (DE)
(74) Vertreter: Continental Corporation

(56) Entgegenhaltungen:
- WO-A1-2014/180811
- WO-A1-2018/138132
- DE-A1-102011 111 081
- DE-A1-102017 217 866

## Beschreibung

Die Erfindung betrifft einen Batteriesensor zur Erfassung von zumindest einem Batterieparameter mit einer Batteriepolklemme zur Kontaktierung mit einem Batteriepol einer Fahrzeugbatterie, einem Kabelanschluss, der elektrisch mit der Batteriepolklemme verbunden ist, einer insbesondere elektrisch zwischen der Batteriepolklemme und dem Kabelanschluss angeordneten Erfassungseinrichtung für den zumindest einen Batterieparameter, wobei an der Batteriepolklemme ein Halteabschnitt zur elektrischen Kontaktierung mit dem Kabelanschluss und/oder der Erfassungseinrichtung vorgesehen ist, und mit einem Gehäuse, dass die Erfassungseinrichtung zumindest abschnittsweise umschließt.

Batteriesensoren werden in Fahrzeugen genutzt, um Batterieparameter, beispielsweise den Batteriestrom oder die Batteriespannung der Fahrzeugbatterie zu erfassen. Üblicherweise weist ein solcher Batteriesensor eine Batteriepolklemme mit einem Ringabschnitt auf, um den Batteriesensor auf einen Pol der Fahrzeugbatterie aufzusetzen, sowie einen Kabelanschluss für ein Kabel, insbesondere ein mit dem Fahrzeugchassis verbundenes Massekabel.

Der Batteriesensor weist beispielsweise einen Messwiderstand auf, der mit dem Batteriepol der Fahrzeugbatterie und dem Anschluss für das Kabel elektrisch verbunden ist. Der Batteriesensor ist so ausgebildet, dass der zwischen dem Kabel und dem Batteriepol fließende Strom vollständig durch den Messwiderstand fließen muss. Der Batteriesensor kann den Spannungsabfall des Stromes über den Messwiderstand erfassen und bei bekanntem elektrischem Widerstand des Messwiderstandes den über den Messwiderstand, also den Batteriesensor, fließenden Strom bestimmen.

Auf das angeschlossene Kabel wirken relativ hohe mechanische Kräfte. Diese können bei der Montage des Kabels, beispielsweise durch Anschrauben des Kabels am Anschluss, oder beim Betrieb des Fahrzeugs entstehen. Im Betrieb des Fahrzeugs treten beispielsweise Vibrationsbelastungen oder Zugbelastungen auf.

Der Batteriesensor muss ausreichend stabil sein, um auch bei vor und während des Betriebes des Fahrzeugs auftretenden Belastungen eine sichere Kontaktierung des Kabels mit dem Batteriepol der Batterie und eine zuverlässige Funktion des Batteriesensors sicherzustellen.

Aus dem Stand der Technik, beispielsweise aus der WO 2014/180 811 A1, ist bekannt, zusätzliche mechanische Halteelemente zu verwenden, um die auf das Kabel wirkenden Kräfte abzufangen. Das Halteelement ist mit dem Kabel und/oder dem Anschluss für das Kabel verbunden und stützt sich an der Batterie, insbesondere am Pol der Batterie, oder an der Anschlussklemme ab. Aus der W 2018/138 132 A1 ist eine Baugruppe bekannt, bei der das Gehäuse auf ein zusätzliches Halteelement aufgeschoben werden kann. Aus der DE 10 2011 111 081 A1 ist eine Baugruppe bekannt, die mehrere Vorsprünge an der Batteriepolklemme aufweist, auf welchen der Messwiderstand gehalten ist. In der DE 2017 217 866 A1 ist eine weitere Baugruppe für einen Batteriesensor gezeigt.

Die Herstellung und Montage solcher zusätzlicher Halteelemente erfordert aber zusätzliche Herstellungsschritte, wodurch die Herstellung der Batteriesensoren aufwändiger und somit teurer wird. Des Weiteren ist der Bauraum für den Batteriesensor, insbesondere in der Polnische der Fahrzeugbatterie, begrenzt, so dass die Anordnung und die Befestigung eines Halteelementes sehr aufwändig sind.

Aufgabe der Erfindung ist es, einen Batteriesensor bereitzustellen, der eine ausreichende Stabilität gegen die im Fahrzeug auftretenden Belastungen aufweist und der kostengünstig und einfach herzustellen ist.

Zur Lösung der Aufgabe ist ein Batteriesensor zur Erfassung von zumindest einem Batterieparameter vorgesehen, mit einer Batteriepolklemme zur Kontaktierung mit einem Batteriepol einer Fahrzeugbatterie, einem Kabelanschluss, der elektrisch mit der Batteriepolklemme verbunden ist, und einer insbesondere elektrisch zwischen der Batteriepolklemme und dem Kabelanschluss angeordneten Erfassungseinrichtung für den zumindest einen Batterieparameter. Die Batteriepolklemme weist einen Ringabschnitt zur Aufnahme des Batteriepols und einen am Ringabschnitt vorgesehen Halteabschnitt zur elektrischen Kontaktierung mit dem Kabelanschluss und/oder der Erfassungseinrichtung auf. Der Batteriesensor weist des Weiteren ein Gehäuse auf, das die Erfassungseinrichtung zumindest abschnittsweise umschließt. Am Ringabschnitt ist zumindest ein vom Halteabschnitt separates Stützelement vorgesehen, dass formschlüssig im Gehäuse aufgenommen ist.

Der Erfindung liegt die Überlegung zugrunde, die Haltefunktion für das Gehäuse bzw. den Kabelanschluss vollständig von der elektrischen Kontaktierung des Kabelanschlusses mit der Batteriepolklemme, also dem Strompfad, zu trennen. Hierzu ist ein Stützelement vorgesehen, das nicht am Halteabschnitt angreift, an dem der Kabelanschluss oder eine Erfassungseinrichtungen kontaktiert sind, sondern separat von diesen unmittelbar am Ringabschnitt, der auf dem Batteriepol gehalten ist, angeordnet ist. Durch die Anordnung unmittelbar am Ringabschnitt ist eine besonders gute Lastaufnahme möglich. Zudem können so die auftretenden Lasten besonders gut von der Erfassungseinrichtungen ferngehalten werden, sodass diese besonders gut vor mechanischen Belastungen geschützt ist. Insbesondere kann das Stützelement weitgehend unabhängig und ausschließlich nach mechanischen Gesichtspunkten und der Einbausituation bemessen werden. Insbesondere ist das Stützelement formschlüssig im Gehäuse aufgenommen, sodass eine unlösbare Verbindung zwischen dem Gehäuse und dem Stützelement hergestellt ist. Ein Lösen der Verbindung zwischen dem Gehäuse und dem Stützelement wird dadurch zuverlässig ausgeschlossen, sodass eine zuverlässige Verbindung zwischen dem Gehäuse und dem Stützelement, also eine zuverlässige Stützfunktion des Gehäuses durch das Stützelement, bereitgestellt ist.

Um einen besonders guten Formschluss zwischen dem Stützelement und dem Gehäuse herzustellen, weist das Stützelement Aussparungen und/oder Vorsprünge auf, die das Gehäuse formschlüssig umschließt. Der Formschluss wird bei der Herstellung des Gehäuses hergestellt. Das Gehäuse wird in einem Spritzgussverfahren hergestellt, wobei das Stützelement, insbesondere die Vorsprünge oder Aussparungen vom Kunststoffmaterial umspritzt werden.

Dadurch sind keine zusätzlichen Herstellungsschritte zur Verbindung des Stützelement und des Gehäuses erforderlich.

Beispielsweise erstreckt sich das Stützelement bezüglich eines durch den Ringabschnitt definierten im Wesentlichen zylindrischen oder konischen Aufnahmeraums zumindest abschnittsweise radial vom Ringabschnitt weg. Insbesondere erstreckt sich das Stützelement in Richtung zu einem Gehäuse, sodass eine direkte Lastableitung von Kräften, die auf das Gehäuse wirken, möglich ist.

Das Stützelement kann sich zudem in Richtung zum Kabelanschluss erstrecken, die auf den Kabelanschluss wirkenden Kräfte besonders gut aufnehmen zu können. Insbesondere ist der Kabelanschluss so angeordnet, dass das Stützelement möglich kurz ausgebildet werden kann, so dass eine bessere Lastaufnahme des Stützelements möglich ist.

Das Stützelement kann sich auch zumindest abschnittsweise im Wesentlichen parallel zum Halteabschnitt oder zur Erfassungseinrichtung erstrecken, um den Halteabschnitt oder die Erfassungseinrichtung vor mechanischen Belastungen zu schützen, indem diese von dem Stützelement aufgenommen werden.

Das Stützelement ist insbesondere vom Halteabschnitt separat, also vollständig von diesen getrennt, so dass die auftretenden Belastungen ausschließlich oder zumindest überwiegend durch das Stützelement aufgenommen werden. Insbesondere kann das Stützelement bezüglich eines durch den Ringabschnitt definierten im Wesentlichen zylindrischen oder konischen Aufnahmeraums in axialer Richtung beabstandet vom Halteabschnitt sein. Beispielsweise ist der Halteabschnitt an einem ersten axialen Ende des Ringabschnitts angeordnet und das Stützelement ist am gegenüberliegenden zweiten axialen Ende des Ringabschnitts angeordnet. Durch die räumliche Trennung des Stützelements und des Halteabschnitts am Ringabschnitt ist zuverlässig verhindert, dass sich auf das Stützelement wirkende Belastungen, die vom Stützabschnitt auf den Ringabschnitt übertragen werden, auf den Halteabschnitt und somit auf die Erfassungseinrichtung auswirken können.

Das Gehäuse kann aus einem faserverstärkten Kunststoff bestehen, wodurch das Gehäuse die auftretenden Kräfte besser aufnehmen kann. Insbesondere können die Fasern des Kunststoffs belastungsgerecht verlegt werden, beispielsweise indem ein Gewebe verwendet wird, das mit dem Kunststoff durchtränkt wird oder von diesem gespritzt wird. Insbesondere können auch nur in hochbelasteten Bereichen des Gehäuses zusätzliche Fasern im Kunststoff vorgesehen sein. Beispielsweise können auch lediglich Verstärkungsbereiche aus einem faserverstärkten Kunststoff vorgesehen sein.

Optional können auch einzelne Verstärkungselemente im Gehäuse vorgesehen sein, die am Stützelement angreifen und eine besonders gute Stützfunktion des Gehäuses bereitstellen.

Insbesondere ist das Gehäuse unlösbar mit dem zumindest einen Halteelemente verbunden.

Die Erfassungseinrichtung kann eine Stromerfassungseinrichtung und/oder eine Spannungserfassungseinrichtung sein.

Beispielsweise weist die Erfassungseinrichtung zumindest einen elektrisch zwischen der Batteriepolklemme und dem Kabelanschluss angeordneten Messwiderstand auf.

Zur Lösung der Aufgabe ist des Weiteren ein Verfahren zu Herstellung eines vorstehend beschriebenen Batteriesensors vorgesehen, das die folgenden Schritte aufweist:
- Bereitstellen der Baugruppe besteht aus Batteriepolklemme, Kabelanschluss und Erfassungseinrichtung,
- Herstellen des Gehäuses im Spritzgießverfahren, wobei das Stützelement in das Gehäuse eingegossen wird.

Die Erfassungseinrichtung und/oder der Kabelanschluss können hierbei mit dem Anschlussabschnitt verbunden werden, insbesondere verschweißt werden.

Die Batteriepolklemme kann in einem Stanz-Biege-Verfahren hergestellt werden, wobei insbesondere das Stützelement umgebogen wird. Das heißt, aus einem ebenen Blechstück wird ein Grundkörper für die Batteriepolklemme ausgestanzt. Anschließend werden Bereiche dieses Grundkörpers durch Biegen oder einem anderen Umformprozess in die endgültige Form der Batteriepolklemme umgeformt. Insbesondere kann das Stützelement durch einen beim Ausstanzen vorgesehenen Vorsprung ausgebildet sein, der beim Umformprozess in die gewünschte Position umgebogen wird.

Weitere Vorteile und Merkmale finden sich in der nachfolgenden Beschreibung in Verbindung mit den beigefügten Zeichnungen. In diesem zeigen:
- Figur 1: eine perspektivische Ansicht einer Widerstandsbaugruppe für einen erfindungsgemäßen Batteriesensor;
- Figur 2: eine Draufsicht auf die Widerstandsbaugruppe in aus Figur 1,
- Figur 3: eine perspektivische Ansicht eines erfindungsgemäßen Batteriesensors mit dem Körper aus Figur 1 ;
- Figur 4: eine Draufsicht auf den Batteriesensor aus Figur 3;
- Figur 5: eine teiltransparente Ansicht des Batteriesensors aus Figur 3;
- Figur 6: eine teiltransparente Ansicht des Batteriesensors aus Figur 4.

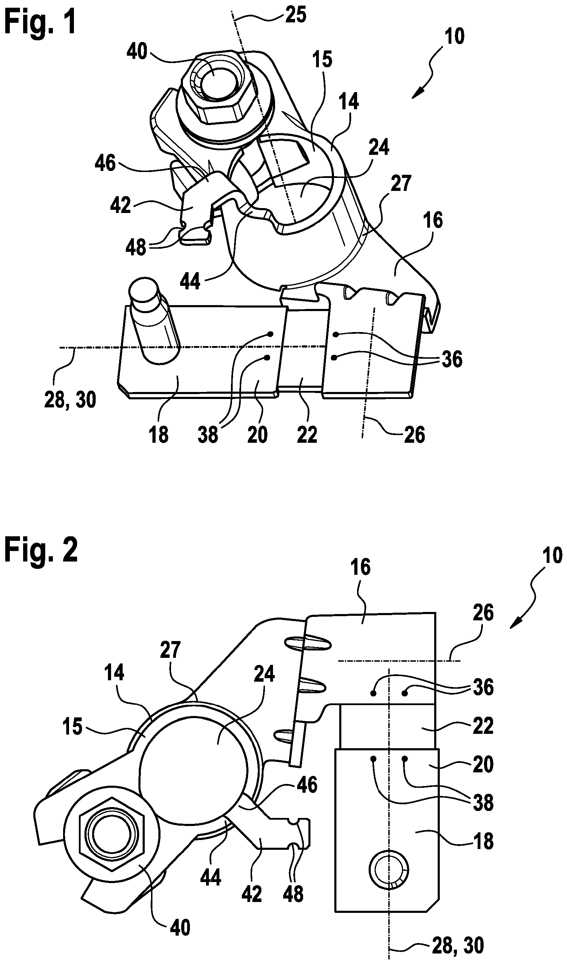

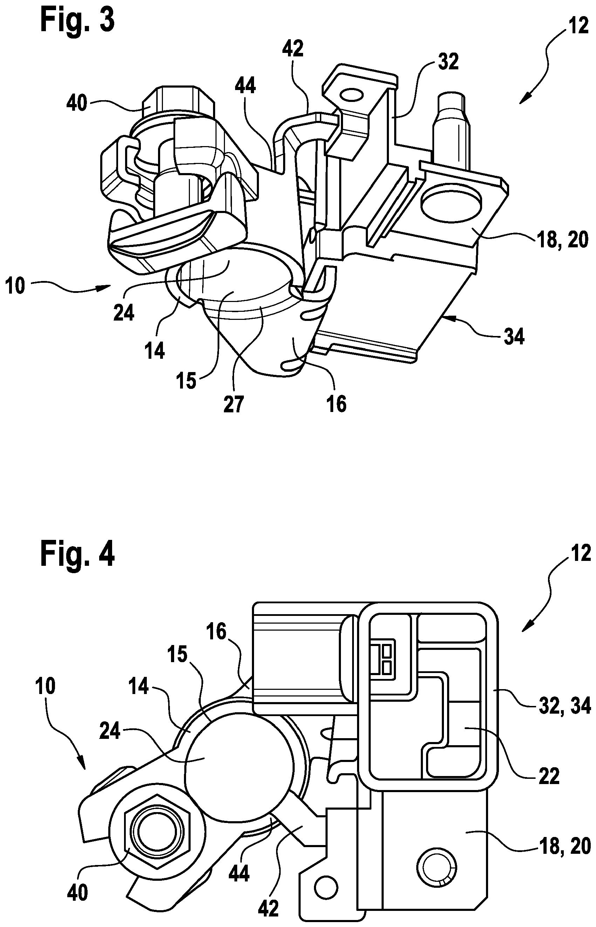

In den Figuren 1 und 2 ist eine Widerstandsbaugruppe 10 für einen in den Figuren 3 bis 6 dargestellten Batteriesensor 12 gezeigt.

Der Widerstandsbaugruppe 10 weist eine Batteriepolklemme 14 mit einem Ringabschnitt 15 und einem ersten Halteabschnitt 16 sowie einen Kabelanschluss 18 mit einem zweiten Halteabschnitt 20 auf. Der erste Halteabschnitt 16 und der zweite Halteabschnitt 20, und somit die Batteriepolklemme 14 und der Kabelanschluss 18, sind über einen Messwiderstand 22 elektrisch und mechanisch miteinander verbunden.

Wie insbesondere in Figur 2 zu sehen ist, erstreckt sich der erste Halteabschnitt 16 bezüglich eines durch die Batteriepolklemme 14 definierten zylindrischen oder konischen Aufnahmeraums 24 im Wesentlichen abschnittsweise radial von diesem weg, wobei der erste Halteabschnitt 14 in der Draufsicht in Figur 2 gebogen ist. Eine Längsachse 26 des ersten Halteabschnitts 16 im Übergang zum Messwiderstand 22 verläuft im Wesentlichen senkrecht zur Längsachse 28 des Messwiderstandes 22. Bezüglich einer Achse 25 des Aufnahmeraums 24 ist der erste Halteabschnitt 14 an einem ersten axialen Ende 27 vorgesehen. Eine Längsachse 30 des zweiten Halteabschnitts 20 verläuft im Wesentlichen parallel zur Längsachse 26 des Messwiderstandes 22 bzw. ist deckungsgleich mit dieser.

Der erste Halteabschnitt 16 sowie der zweite Halteabschnitt 20 können unabhängig davon aber beliebig ausgebildet sein. Insbesondere kann diese an die Einbausituation in einem Fahrzeug bzw. in der Polnische einer Fahrzeugbatterie, angepasst werden. Beispielsweise sind der erste Halteabschnitt 16, der zweite Halteabschnitt 20 sowie der Messwiderstand 22 U-förmig angeordnet.

Wie insbesondere in Figur 1 zu sehen ist, sind der erste Halteabschnitt 16, der zweite Halteabschnitt 20 sowie der Messwiderstand 22 eben ausgebildet und befinden sich im Wesentlichen in einer Ebene.

Die Widerstandsbaugruppe 10 ist insbesondere aus einem ebenen Blech hergestellt, wobei für die verschiedenen Bereiche der Widerstandsbaugruppe, also die Batteriepolklemme 14, den Messwiderstand 22 und den Kabelanschluss 18 verschiedene Materialien vorgesehen sein können, die vorab miteinander verbunden sind, beispielsweise durch ein Schweißverfahren. Beispielsweise bestehen die Halteabschnitte 16, 20 aus Kupfer oder einer Kupferlegierung.

Zur Herstellung der Widerstandsbaugruppe 10 wird zunächst aus dem Blech ein Grundkörper ausgestanzt. Dieser Grundkörper wird anschließend in die gewünschte Form umgeformt, wobei insbesondere die Batteriepolklemme 14 durch Biegen oder einen anderen Umformprozess ausgebildet wird.

Die in den Figuren 1 und 2 gezeigte Widerstandsbaugruppe 10 ist Teil eines in den Figuren 3 bis 6 dargestellten Batteriesensors 12.

Der Batteriesensor 12 weist zusätzlich ein Gehäuse 32 auf, in dem zumindest eine Erfassungseinrichtung 34 für zumindest einen Batterieparameter vorgesehen ist. In der hier gezeigten Ausführungsform ist die Erfassungseinrichtungen 34 dazu ausgebildet, einen Spannungsabfall zwischen auf dem ersten Halteabschnitt 16 und dem zweiten Halteabschnitt 20 angeordneten ersten Kontaktstellen 36 und zweiten Kontaktstellen 38, also über den Messwiderstand 22 zu erfassen.

Der Batteriesensor 12 wird üblicherweise mit dem Ringabschnitt 15 der Batteriepolklemme 14 auf eine Batteriepol aufgesetzt. Anschließend wird die Batteriepolklemme durch eine Spanneinrichtung 40 auf dem Batteriepol verklemmt und dadurch der Batteriesensor 12 an der Fahrzeugbatterie gehalten. Am Kabelanschluss 18 wird beispielsweise ein Massekabel angeschlossen. Der Batteriesensor 12 ist so angeordnet, dass der gesamte Strom der Fahrzeugbatterie über den Batteriesensor fließt.

Der elektrische Widerstand des Messwiderstandes 22 ist bekannt. Beispielsweise besteht der Messwiderstand 22 aus einer Kupfer-Nickel-Mangan-Legierung, die eine geringe Temperaturabhängigkeit des elektrischen Widerstandes aufweist. Alternativ kann der Messwiderstand 22 aus einem anderen für einen Messwiderstand geeigneten real bestehen, beispielsweise aus Kupfer oder einer Kupferlegierung. Weist das Material eine höhere Temperaturabhängigkeit des elektrischen Widerstandes auf, ist diese Temperaturabhängigkeit vorzugsweise vorab zu ermitteln sodass der elektrische Widerstand in Abhängigkeit von der Temperatur des Messwiderstandes 22 genau bestimmt werden kann, oder der elektrische Widerstand wird während des Betriebs des Batteriesensors bestimmt.

Aus dem erfassten Spannungsabfall über den Messwiderstand 22 sowie dem bekannten elektrischen Widerstand des Messwiderstandes 22 kann der über den Batteriesensor 12 fließende Strom berechnet werden.

Zusätzlich kann der Batteriesensor 12 auch weitere hier nicht im Detail gezeigte Erfassungseinrichtungen, beispielsweise eine Spannungserfassungseinrichtung zur Erfassung einer Batteriespannung oder eine Temperaturerfassungseinrichtung zur Erfassung der Batterietemperatur aufweisen.

Im Fahrzeugbetrieb wirken auf den Batteriesensor 12, insbesondere durch das am Kabelanschluss 18 angeschlossene Kabel, mechanische Kräfte, beispielsweise Zugkräfte oder Vibrationen. Zusätzlich wirken auch während der Montage, insbesondere der Montage des Kabels am Kabelanschluss 18 mechanische Kräfte auf den Batteriesensor 12. Um die zuverlässige Funktion des Batteriesensors 12 zu gewährleisten, muss die Erfassungseinrichtung 26 zuverlässig vor zu hohen mechanischen Beanspruchungen geschützt werden. Zudem muss eine zuverlässige Kontaktierung des am Kabelanschluss 18 angeschlossenen Kabels mit der Fahrzeugbatterie sichergestellt sein.

Hierzu ist an der Batteriepolklemme 14 ein Stützelement 42 vorgesehen. Das Stützelement ist bezüglich des Aufnahmeraums 24 an einem dem ersten axialen Ende 27 entgegengesetzten zweiten axialen Ende 44 vorgesehen. Insbesondere ist das Stützelement 42 durch einen umgebogenen Vorsprung 46 gebildet, der einstückig mit der Batteriepolklemme 14 ausgebildet ist, also bereits beim Ausstanzen des Grundkörpers vorgesehen wurde. Der Vorsprung 46 erstreckt sich mit einem ersten Abschnitt in axialer Richtung und mit einem zweiten Abschnitt in Richtung zum Kabelanschluss 18. Wie in den Figuren 1 und 2 zu sehen ist, weist das Stützelement 42 zwei an entgegengesetzten Rändern vorgesehene Aussparungen 48 auf.

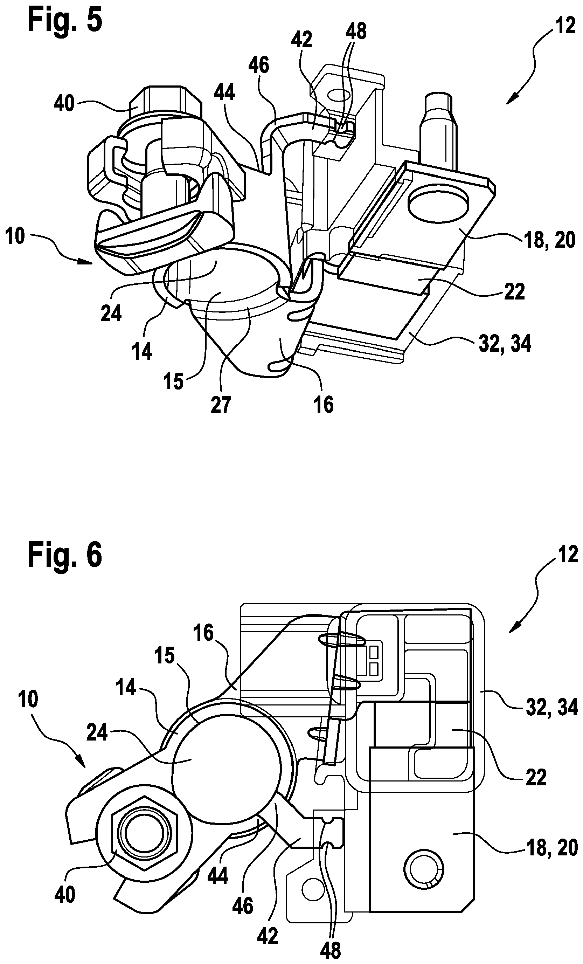

Wie in den Figuren 5 und 6 zu sehen ist, erstreckt sich das Stützelement 42 in das Gehäuse 32 bzw. ist in diesen aufgenommen. Insbesondere ist das Gehäuse 32 aus Kunststoff in einem Spritzgussverfahren hergestellt, wobei das Stützelement 42 von dem Kunststoffmaterial umschlossen und formschlüssig in diesen aufgenommen ist. Dadurch ist das Stützelement unlösbar mit dem Gehäuse 32 verbunden.

Das Gehäuse 32 umschließt die gesamte Erfassungseinrichtungen 34 sowie zumindest abschnittsweise den ersten Halteabschnitt 16 und den zweiten Halteabschnitt 20. Somit ist die Erfassungseinrichtung 34 mit den angrenzenden Halteabschnitten 16, 20 durch das Gehäuse 32 stabilisiert und gestützt. Das Gehäuse 32 ist durch das Stützelement 42 stabilisiert und sicher gehalten, sodass Belastungen auf das Gehäuse zuverlässig auf die Batteriepolklemme 14 bzw. den Ringabschnitt 15 abgeleitet werden können. Insbesondere erstreckt sich das Stützelement 42 in Richtung zum Kabelanschluss 18, sodass Belastungen auf den Kabelanschluss 18 bzw. auf das am Kabelanschluss 18 angeschlossene Kabel zuverlässig vom Stützelement 42 aufgenommen werden können, sodass diese nicht auf die Erfassungseinrichtung 34 einwirken können.

Da das Stützelement 42 an einem dem ersten Halteabschnitt 14 gegenüberliegenden Ende 44 des Ringabschnitts 15 angeordnet ist, ist zudem eine Trennung der mechanischen Stützfunktion des Kabelanschlusses 18 bzw. des Gehäuses 32 durch das Stützelement 42 und der elektrischen Kontaktierung des Kabelanschlusses 18 mit der Batteriepolklemme durch den ersten Halteabschnitt 16, den Messwiderstand 22 und den zweiten Halteschnitt 20 vorhanden. Das Stützelement 42 kann somit überwiegend nach mechanischen Gesichtspunkten konstruiert werden, während der Halteabschnitt 16, der Messwiderstand 22 und der zweite Halteabschnitt 42 rein nach elektrischen Gesichtspunkten bemessen werden können.

Insbesondere ist das Gehäuse 32 aus einem faserverstärkten Kunststoff, insbesondere einem Thermoplast, hergestellt und kann somit sehr hohe mechanische Belastungen aufnehmen und an das Stützelement 42 weiterleiten. Zusätzlich kann das Gehäuse 32 Verstärkungselemente aufweisen, insbesondere aus einem faserverstärkten Kunststoff, die die mechanische Stabilität des Gehäuses 32 verbessern.

Da das Gehäuse 32 aus Kunststoff hergestellt ist, ist zudem eine sehr gute Isolierung des Stützelement 42 gegenüber der Erfassungseinrichtungen 34 bzw. den Halteabschnitten 16, 20 und dem Messwiderstand 22 gewährleistet.

Insbesondere sind, wie in den Figuren 2 und 4 zu sehen ist, der erste Halteabschnitt 16, der zweite Halteabschnitt 20 und der Messwiderstand 22 so ausgebildet, dass die Entfernung zwischen dem Kabelanschluss 18 und der Batteriepolklemme 14 möglichst gering ist. Dadurch kann das Stützelement 42 kürzer ausgebildet werden, sodass dieses die auftretenden Belastungen besser aufnehmen kann. Insbesondere sind erste Halteabschnitt 16, der zweite Halteabschnitt 20 und der Messwiderstand 22 U-förmig ausgebildet.

Unabhängig von der Form bzw. der Anordnung des ersten Halteabschnitts 16, des zweiten Halteabschnitts 20 und des Messwiderstandes 22 kann das Stützelement 42 so ausgebildet sein, dass dieses die auftretenden Belastungen, insbesondere auf den Kabelanschluss 18, aufnehmen kann. Insbesondere kann das Stützelement 42 auch zumindest abschnittsweise parallel zum ersten Halteabschnitt 16, zum zweiten Halteabschnitt 20 und/oder zum Messwiderstand 22 verlaufen.

### Bezugszeichenliste

- 10: Widerstandsbaugruppe
- 12: Batteriesensor
- 14: Batteriepolklemme
- 15: Ringabschnitt
- 16: erster Halteabschnitt
- 18: Kabelanschluss
- 20: zweiter Halteabschnitt
- 22: Messwiderstand
- 24: Aufnahmeraum
- 25: Längsachse des Aufnahmeraums
- 26: Längsachse des erste Halteabschnitts
- 27: erstes axiales Ende des Ringabschnitts
- 28: Längsachse des Messwiderstandes
- 30: Längsachse des zweiten Halteabschnitts
- 32: Gehäuse
- 34: Erfassungseinrichtung
- 36: erste Kontaktstelle
- 38: zweite Kontaktstelle
- 40: Spanneinrichtung
- 42: Stützelement
- 44: zweites axiales Ende des Ringabschnitts
- 46: Vorsprung
- 48: Aussparungen

## Patentansprüche

1. Batteriesensor (12) zur Erfassung von zumindest einem Batterieparameter mit einer Batteriepolklemme (14) zur Kontaktierung mit einem Batteriepol einer Fahrzeugbatterie, einem Kabelanschluss (18), der elektrisch mit der Batteriepolklemme (14) verbunden ist, einer elektrisch zwischen der Batteriepolklemme (14) und dem Kabelanschluss (18) angeordneten Erfassungseinrichtung (34) für den zumindest einen Batterieparameter, wobei die Batteriepolklemme (14) einen Ringabschnitt (15) zur Aufnahme des Batteriepols und einen am Ringabschnitt (15) vorgesehen Halteabschnitt (16) zur elektrischen Kontaktierung mit dem Kabelanschluss (18) und/oder der Erfassungseinrichtung (34) aufweist, und mit einem Gehäuse (32), das die Erfassungseinrichtung (34) zumindest abschnittsweise umschließt, wobei am Ringabschnitt (15) zumindest ein vom Halteabschnitt (16) separates Stützelement (42) vorgesehen ist, das formschlüssig im Gehäuse (32) aufgenommen ist, **dadurch gekennzeichnet, dass** das Stützelement (42) Aussparungen (48) und/oder Vorsprünge aufweist, die das Gehäuse (32) formschlüssig umschließt, wobei das Gehäuse in einem Spritzgussverfahren hergestellt ist und die Vorsprünge oder Aussparungen vom Kunststoffmaterial umspritzt sind.,

2. Batteriesensor nach Anspruch 1, **dadurch gekennzeichnet, dass** sich das Stützelement (42) bezüglich eines durch den Ringabschnitt (15) definierten im Wesentlichen zylindrischen oder konischen Aufnahmeraums (24) radial vom Ringabschnitt (15) weg erstreckt.

3. Batteriesensor nach einem der Ansprüche 1 und 2, **dadurch gekennzeichnet, dass** sich das Stützelement (42) in Richtung zum Kabelanschluss (18) erstreckt.

4. Batteriesensor nach einem der vorhergehenden Ansprüche, **dadurch gekennzeichnet, dass** sich das Stützelement (42) zumindest abschnittsweise im Wesentlichen parallel zum Halteabschnitt (16) erstreckt.

5. Batteriesensor nach einem der vorhergehenden Ansprüche, **dadurch gekennzeichnet, dass** das Stützelement (42) bezüglich eines durch den Ringabschnitt (15) definierten im Wesentlichen zylindrischen oder konischen Aufnahmeraums (24) in axialer Richtung beabstandet vom Halteabschnitt (14) ist.

6. Batteriesensor nach einem der vorhergehenden Ansprüche, **dadurch gekennzeichnet, dass** das Gehäuse (32) zumindest abschnittsweise aus einem faserverstärkten Kunststoff besteht.

7. Batteriesensor nach einem der vorhergehenden Ansprüche, **dadurch gekennzeichnet, dass** das Gehäuse (32) unlösbar mit dem zumindest einen Halteelemente (16) verbunden ist.

8. Batteriesensor nach einem der vorhergehenden Ansprüche, **dadurch gekennzeichnet, dass** die Erfassungseinrichtung (34) eine Stromerfassungseinrichtung und/oder eine Spannungserfassungseinrichtung ist.

9. Batteriesensor nach einem der vorhergehenden Ansprüche, **dadurch gekennzeichnet, dass** die Erfassungseinrichtung (34) zumindest einen elektrisch zwischen der Batteriepolklemme (14) und dem Kabelanschluss (18) angeordneten Messwiderstand (22) aufweist.

10. Verfahren zu Herstellung eines Batteriesensors nach einem der vorhergehenden Ansprüche, mit folgenden Schritten:
- Bereitstellen der Baugruppe bestehend aus Batteriepolklemme (14), Kabelanschluss (18) und Erfassungseinrichtung (34),
- Herstellen des Gehäuses (32) im Spritzgießverfahren, wobei die Vorsprünge oder Aussparungen des Stützelements (42) in das Gehäuse (32) eingegossen werden.

11. Verfahren nach Anspruch 11, **dadurch gekennzeichnet, dass** die Erfassungseinrichtung (34) und/oder der Kabelanschluss (18) mit dem Halteabschnitt (14) verbunden werden, insbesondere verschweißt werden.

12. Verfahren nach einem der Ansprüche 11 und 12, **dadurch gekennzeichnet, dass** die Batteriepolklemme (14) in einem Stanz-Biege-Verfahren hergestellt wird, wobei insbesondere das Stützelement (42) umgebogen wird.

## Claims

1. Battery sensor (12) for detecting at least one battery parameter, having a battery pole terminal (14) for making contact with a battery pole of a vehicle battery, a cable connection (18) electrically connected to the battery pole terminal (14), a detection device (34), electrically arranged between the battery pole terminal (14) and the cable connection (18), for the at least one battery parameter, wherein the battery pole terminal (14) has an annular section (15) for receiving the battery pole and a retaining section (16), provided on the annular section (15), for making electrical contact with the cable connection (18) and/or the detection device (34), and having a housing (32) that at least partially encloses the detection device (34), there being provision on the annular section (15) for at least one supporting element (42), separate from the retaining section (16), that is received in the housing (32) in positively locking fashion, **characterized in that** the supporting element (42) has cutouts (48) and/or projections that the housing (32) encloses in positively locking fashion, the housing being produced using an injection moulding process and the projections or cutouts being encapsulated by the plastic material.

2. Battery sensor according to Claim 1, **characterized in that** the supporting element (42) extends radially away from the annular section (15) in regard to a substantially cylindrical or conical receiving space (24) defined by the annular section (15).

3. Battery sensor according to either of Claims 1 and 2, **characterized in that** the supporting element (42) extends in the direction of the cable connection (18).

4. Battery sensor according to one of the preceding claims, **characterized in that** at least part of the supporting element (42) extends substantially parallel to the retaining section (16).

5. Battery sensor according to one of the preceding claims, **characterized in that** the supporting element (42) is at a distance from the retaining section (14) in the axial direction in regard to a substantially cylindrical or conical receiving space (24) defined by the annular section (15).

6. Battery sensor according to one of the preceding claims, **characterized in that** at least part of the housing (32) consists of a fibre-reinforced plastic.

7. Battery sensor according to one of the preceding claims, **characterized in that** the housing (32) is non-detachably connected to the at least one retaining element (16).

8. Battery sensor according to one of the preceding claims, **characterized in that** the detection device (34) is a current detection device and/or a voltage detection device.

9. Battery sensor according to one of the preceding claims, **characterized in that** the detection device (34) has at least one measuring resistor (22) electrically arranged between the battery pole terminal (14) and the cable connection (18).

10. Method for producing a battery sensor according to one of the preceding claims, having the following steps:
- providing the assembly consisting of the battery pole terminal (14), the cable connection (18) and the detection device (34),
- producing the housing (32) using the injection moulding process, wherein the projections or cutouts of the supporting element (42) are encapsulated in the housing (32).

11. Method according to Claim 11, **characterized in that** the detection device (34) and/or the cable connection (18) are connected, in particular welded, to the retaining section (14).

12. Method according to either of Claims 11 and 12, **characterized in that** the battery pole terminal (14) is produced using a stamping-bending process, wherein in particular the supporting element (42) is bent.

## Revendications

1. Capteur de batterie (12) servant à détecter au moins un paramètre de batterie, comportant une borne de batterie (14) destinée à être mise en contact avec un pôle de batterie d'une batterie de véhicule, un connecteur de câble (18) qui est relié électriquement à la borne de batterie (14), un dispositif de détection (34) disposé électriquement entre la borne de batterie (14) et le connecteur de câble (18) pour ledit au moins un paramètre de batterie, dans lequel la borne de batterie (14) comporte une partie annulaire (15) destinée à recevoir la borne de batterie et une partie de maintien (16) prévue sur la partie annulaire (15) pour la mise en contact électrique avec le connecteur de câble (18) et/ou le dispositif de détection (34), et comportant un boîtier (32) qui entoure au moins en partie le dispositif de détection (34), dans lequel il est prévu, sur la partie annulaire (15), au moins un élément de support (42) séparé de la partie de maintien (16), qui est logé par complémentarité de forme dans le boîtier (32), **caractérisé en ce que** l'élément de support (42) présente des évidements (48) et/ou des saillies qui entourent le boîtier (32) par complémentarité de forme, dans lequel le boîtier est fabriqué par un procédé de moulage par injection et les saillies ou les évidements sont enrobés par la matière plastique.

2. Capteur de batterie selon la revendication 1, **caractérisé en ce que** l'élément de support (42) s'étend radialement depuis la partie annulaire (15) par rapport à un espace de logement (24) sensiblement cylindrique ou conique défini par la partie annulaire (15).

3. Capteur de batterie selon l'une des revendications 1 et 2, **caractérisé en ce que** l'élément de support (42) s'étend en direction du connecteur de câble (18).

4. Capteur de batterie selon l'une des revendications précédentes, **caractérisé en ce que** l'élément de support (42) s'étend, au moins en partie, sensiblement parallèlement à la partie de maintien (16).

5. Capteur de batterie selon l'une des revendications précédentes, **caractérisé en ce que** l'élément de support (42) est espacé de la partie de maintien (14) dans la direction axiale par rapport à un espace de logement (24) sensiblement cylindrique ou conique défini par la partie annulaire (15).

6. Capteur de batterie selon l'une des revendications précédentes, **caractérisé en ce que** le boîtier (32) est constitué au moins en partie d'une matière plastique renforcée par des fibres.

7. Capteur de batterie selon l'une des revendications précédentes, **caractérisé en ce que** le boîtier (32) est relié de manière inamovible audit au moins un élément de maintien (16).

8. Capteur de batterie selon l'une des revendications précédentes, **caractérisé en ce que** le dispositif de détection (34) est un dispositif de détection de courant et/ou un dispositif de détection de tension.

9. Capteur de batterie selon l'une des revendications précédentes, **caractérisé en ce que** le dispositif de détection (34) comporte au moins une résistance de mesure (22) disposée électriquement entre la borne de batterie (14) et le connecteur de câble (18).

10. Procédé de fabrication d'un capteur de batterie selon l'une des revendications précédentes, comprenant les étapes consistant à :
- fournir le sous-ensemble constitué de la borne de batterie (14), du connecteur de câble (18) et du dispositif de détection (34),
- fabriquer le boîtier (32) par un procédé de moulage par injection, dans lequel les saillies ou les évidements de l'élément de support (42) sont moulés dans le boîtier (32).

11. Procédé selon la revendication 11, **caractérisé en ce que** le dispositif de détection (34) et/ou le connecteur de câble (18) sont reliés, en particulier soudés, à la partie de maintien (14).

12. Procédé selon l'une des revendications 11 et 12, **caractérisé en ce que** la borne de batterie (14) est fabriquée par un procédé de découpe et de pliage, dans lequel l'élément de support (42) est notamment replié.
